# EUROPEAN PATENT APPLICATION

(11) **EP 4 819 591 A1**
(43) Date of publication of application: **07.10.2026**
(21) Application number: 25210945.9
(22) Date of filing: 24.10.2025
(51) Int. Cl.: H04M 1/23, H04M 1/18, H04M 1/02

(54) **INTELLIGENT TERMINAL**

(30) Priority: 31.03.2025 CN 202510397844
(71) Applicant: Beijing Zitiao Network Technology Co., Ltd., Beijing 100190 (CN)
(72) Inventor: XIE, Chun, Beijing, 100028 (CN)
(74) Representative: Isarpatent

(57) **Abstract**

The present disclosure relates to the field of electronic product technologies, and in particular, to an intelligent terminal, which includes a housing, a back cover, a screen, an FPC assembly and a button assembly. The back cover is arranged at the bottom portion of the housing and hermetically connected to the housing. The screen is arranged at the top portion of the housing and hermetically connected to the housing. A button through hole for the button assembly to extend into is formed in an outer peripheral side of the housing. A side of the housing facing the screen is provided with an accommodating groove for accommodating the FPC assembly. The accommodating groove is communicated with the button through hole, and the screen covers the accommodating groove.

## Description

The present disclosure claims the priority of the Chinese Patent Application No. 2025103978442 filed on March 31, 2025, the entire contents disclosed by the Chinese patent application are hereby incorporated by reference as a part of the present disclosure.

### TECHNICAL FIELD

The present disclosure relates to the field of electronic product technologies, and in particular, to an intelligent terminal.

### BACKGROUND

With the widespread use of mobile phones in daily life, the mobile phones not only have a basic communication function, but also have functions such as photographing, video recording, games, music playing, and the like. With the increasing functions of the mobile phones, side keys of the mobile phones are also widely used, for example, for volume adjustment, taking pictures, and the like.

At present, a commonly used side key structure is usually a cooperation between a key and an FPC assembly, and the key presses and triggers the FPC assembly when being pressed, thereby realizing a key function. A screen is arranged on the top portion of a middle frame of the mobile phone, and a battery cover is arranged on the bottom portion of the middle frame. A key slot is formed in an outer peripheral side of the middle frame. Moreover, in order to fix the FPC assembly, a mounting hole is formed in the bottom portion of the middle frame. The bottom portion of the middle frame is also bonded to the battery cover, so as to realize the fixing between the middle frame and the battery cover and the waterproof sealing.

### SUMMARY

In order to solve the above technical problem, the present disclosure provides an intelligent terminal.

The present disclosure provides an intelligent terminal, which includes a housing, a back cover, a screen, an FPC assembly and a button assembly. The back cover is arranged at a bottom portion of the housing and hermetically connected to the housing. The screen is arranged at a top portion of the housing and hermetically connected to the housing. A button through hole for the button assembly to extend into is formed in an outer peripheral side of the housing. A side of the housing facing the screen is provided with an accommodating groove for accommodating the FPC assembly. The accommodating groove is communicated with the button through hole, and the screen covers the accommodating groove.

In some embodiments, the intelligent terminal further includes a sealing piece connected to the housing and covering the accommodating groove to separate the accommodating groove from the screen.

In some embodiments, the housing includes an ear plate extending toward the inner side of the housing. A through hole for the FPC assembly to pass through is formed in the ear plate. The FPC assembly extends out of the accommodating groove and extends to the inner side of the housing through the through hole. The sealing piece hermetically covers the through hole.

In some embodiments, the intelligent terminal further includes a button bracket arranged in the accommodating groove and provided with a limiting cavity for limiting the FPC assembly.

In some embodiments, the button bracket is U-shaped, and the FPC assembly is clamped between side walls of the button bracket.

In some embodiments, in an axial direction of the button through hole, the width of the accommodating groove is 0.3 mm-5 mm.

In some embodiments, the top portion of the housing is provided with a stepped surface including a first supporting surface and a second supporting surface. The accommodating groove is formed in the housing at the second supporting surface. The screen is arranged on the first supporting surface.

In some embodiments, the button assembly includes a button body slidably arranged on the housing and a button needle body hermetically arranged in the button through hole. The button body is configured to drive the button needle body to move in the button through hole to trigger the FPC assembly when being pressed.

In some embodiments, a buffer piece capable of contacting the FPC assembly is arranged at the front end of the button needle body.

In some embodiments, a button mounting groove communicated with the button through hole is formed in the outer peripheral side of the housing. The button body is arranged in the button mounting groove, and partially extends out of the button mounting groove.

In some embodiments, the intelligent terminal is a mobile phone.

### BRIEF DESCRIPTION OF DRAWINGS

The drawings herein, which are incorporated in and constitute a part of this specification, illustrate embodiments consistent with the present disclosure and, together with the description, serve to explain the principles of the present disclosure.

In order to more clearly explain the technical solutions in the embodiments of the present disclosure or in the existing art, the drawings required to be used in the description of the embodiments or the existing art will be briefly introduced below. Obviously, for those of ordinary skill in the art, other drawings may be obtained according to these drawings without paying any creative labor.
Fig. 1 is a schematic partial cross-sectional view of an intelligent terminal in the existing art;
Fig. 2 is a schematic partial structural view of an intelligent terminal according to an embodiment of the present disclosure;
Fig. 3 is a schematic structural view of a housing according to an embodiment of the present disclosure;
Fig. 4 is an exploded schematic view of Fig. 2; and
Fig. 5 is a schematic cross-sectional view of Fig. 2.

Among them, 1', middle frame; 11', mounting hole; 2', battery cover; 3', FPC assembly; 4', screen; 5', button;
1, housing; 1a, first supporting surface; 1b, second supporting surface; 11, button through hole; 12, accommodating groove; 13, ear plate, 131, through hole; 14, clamping piece accommodating groove; 15, buckle hole; 16, button mounting groove;
2, back cover;
3, screen;
4, FPC assembly; 41, FPC body; 42, trigger shrapnel;
5, button assembly; 51, button body; 511, button needle body; 512, buckle; 52, buffer piece;
6, sealing piece;
7, clamping piece; and
8, sealant.

### DETAILED DESCRIPTION

In order to understand the above objects, features and advantages of the present disclosure more clearly, the solutions of the present disclosure will be further described below. It should be noted that the embodiments of the present disclosure and the features in the embodiments may be combined with each other without conflict.

Many specific details are set forth in the following description to facilitate a full understanding of the present disclosure, but the present disclosure may also be implemented in other ways different from those described herein. Obviously, the described embodiments are part of the embodiments of the present disclosure, but not all of the embodiments.

In the existing art, in order to fix the FPC assembly, a mounting hole is formed in the bottom portion of the middle frame. The bottom portion of the middle frame is also bonded to the battery cover, so as to realize the fixing between the middle frame and the battery cover and the waterproof sealing. However, due to the arrangement of the mounting hole, the bonding width between the top portion of the middle frame and the battery cover at the mounting hole is reduced. In order to meet the waterproof requirement, the width of the middle frame usually needs to be increased, which leads to an increase in the width of the mobile phone and poor user experience.

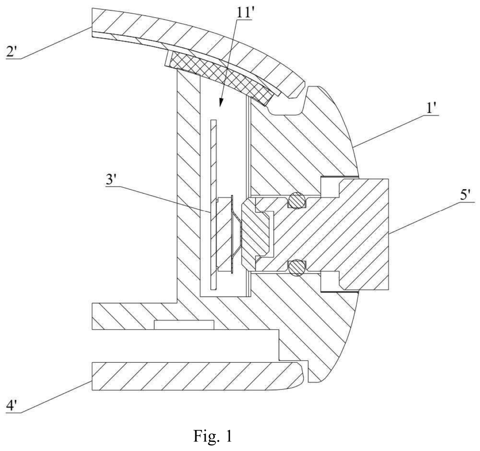

Referring to Fig. 1, in the related art, a commonly used side button structure is usually a cooperation between a button 5' and an FPC assembly 4', and the FPC assembly 4' is triggered when the button 5' is pressed. A screen 4' is arranged on the top portion of a middle frame 1' of a mobile phone, and a battery cover 2' is arranged on the bottom portion of the middle frame 1'. A button slot is formed in an outer peripheral side of the middle frame 1'. The button 5' is slidably arranged on the middle frame 1', and partially extends out of the button slot. Moreover, in order to fix the FPC assembly 4', a mounting hole 11' is formed in the bottom portion of the middle frame 1'. Because the battery cover 2' is adhesively connected to the middle frame 1', a certain bonding area needs to be ensured in order to ensure the waterproof strength. However, the arrangement of the mounting hole 11' reduces the bonding area between the middle frame 1' and the battery cover 2' at the mounting hole 11', affecting the waterproof effect. In this way, the width of the middle frame 1' needs to be increased to ensure the bonding area, which leads to an increase in the width of the mobile phone and affects the user experience.

Specifically, the bottom portion of the middle frame 1' may be divided into a first area and a second area, where the second area is closer to the outer peripheral side of the middle frame 1' than the first area. The first area is provided with a bonding surface for bonding with the battery cover 2'. The second area or a junction between the first area and the second area is provided with a clamping piece accommodating groove for accommodating a clamping piece clamped with the button 5'. The mounting hole 11' is formed in the first area, which affects the width of the bonding surface in the sliding direction of the button 5'. Therefore, in order to ensure the width of the bonding surface to guarantee the waterproof effect, the width of the first area needs to be increased, resulting in an increase in the dimension of the mobile phone.

Therefore, in order to solve the above problems, an embodiment of the present disclosure provides an intelligent terminal, which may be an electronic device with a side button, such as a mobile phone or a tablet, which is not specifically limited herein. The side button refers to that the button is located on a side of the intelligent terminal in the width direction. For example, when the intelligent terminal is a mobile phone, the left side of the mobile phone has a volume up button and a volume down button, and the right side of the mobile phone is provided with a power button, and the power button is used to control the turning on and turning off of the screen of the mobile phone. Certainly, the side button may also be understood as that the button is located on a side of the intelligent terminal in the length direction. For example, a switch button of a tablet is located on a side of the tablet in the length direction, and in this case, a power button is located on the top or bottom portion of the tablet.

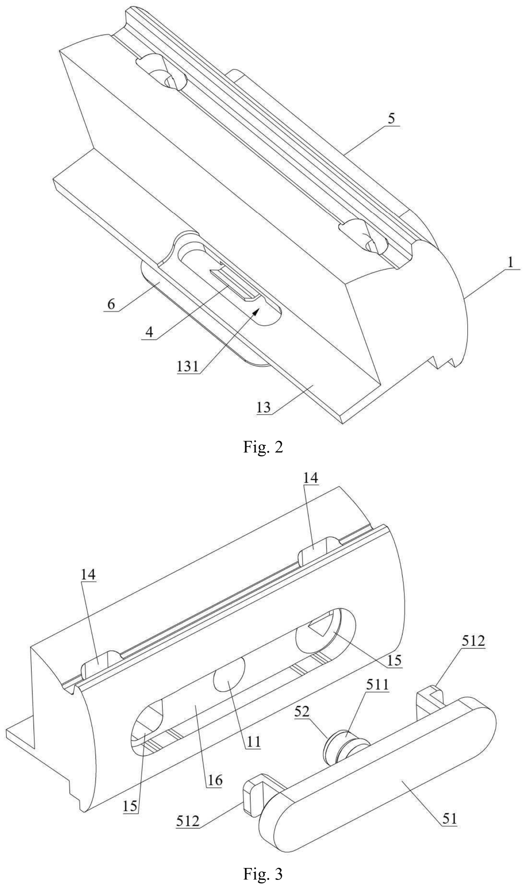

Specifically, referring to Fig. 2 to Fig. 5, the intelligent terminal includes a housing 1, a back cover 2, a screen 3, an FPC assembly 4 and a button assembly 5. The back cover 2 is arranged at the bottom portion of the housing 1 and hermetically connected to the housing 1. The screen 3 is arranged at the top portion of the housing 1 and hermetically connected to the housing 1. A button through hole 11 for the button assembly 5 to extend into is formed in an outer peripheral side of the housing 1. A side of the housing 1 facing the screen 3 is provided with an accommodating groove 12 for accommodating the FPC assembly 4. The accommodating groove 12 is communicated with the button through hole 11, and the screen 3 covers the accommodating groove 12.

It may be understood that the back cover 2 is arranged at the bottom portion of the housing 1 and hermetically connected to the housing 1, the screen 3 is arranged at the top portion of the housing 1 and hermetically connected to the housing 1, the button through hole 11 is formed in the outer peripheral side of the housing 1, the accommodating groove 12 for accommodating the FPC assembly 4 is formed in the top portion of the housing 1, and the accommodating groove 12 is communicated with the button through hole 11. In this way, by forming the accommodating groove 12 in the top portion of the housing 1, the sealing connection between the housing 1 and the back cover 2 is not affected, the waterproof effect is ensured, and the width of the housing 1 in the axial direction of the button through hole 11 may be reduced, thereby reducing the dimension of the intelligent terminal in the axial direction of the button through hole 11 and improving the user experience.

Moreover, the screen 3 covers the accommodating groove 12, so that the accommodating groove 12 may be covered by the screen 3, and the sealing between the screen 3 and the housing 1 may also be used to realize the sealing of the accommodating groove 12.

The housing 1, the screen 3 and the back cover 2 enclose to form an accommodating space. The housing 1 may be a middle frame, and the middle frame presents an annular structure. In this case, the screen 3 may be configured as a front cover of the intelligent terminal. The housing may also be a housing with an inner cavity. In this case, the back cover is connected to the housing, and the screen is arranged on the housing. Alternatively, the housing and the screen are connected to form a U-shaped structure, and the back cover is also configured as a U-shaped structure. In this case, the two U-shaped structures enclose to form the accommodating space, where a side wall of each U-shaped structure is connected to an intermediate wall of the other U-shaped structure. Still alternatively, the housing 1 and the screen are connected to form an upper housing with an inner cavity, the back cover 2 is configured as a lower housing with an inner cavity, and the upper housing and the lower housing are connected and enclose to form the accommodating space.

It should be noted that the back cover 2 is adhesively connected to the bottom portion of the housing 1, and the accommodating groove 12 is formed in the top portion of the housing 1. The accommodating groove 12 does not affect the bonding area between the bottom portion of the housing 1 and the back cover 2, thereby ensuring the bonding area between the housing 1 and the back cover 2, and reducing the dimension of the intelligent terminal while meeting the waterproof requirement.

The button assembly 5 may be arranged on a side of the intelligent terminal in the length direction, or may be arranged on a side of the intelligent terminal in the width direction. For example, taking the intelligent terminal as a mobile phone for an example, the button assembly is located on a side of the mobile phone in the width direction. In this case, the housing may be a middle frame of the mobile phone, and the mobile phone further includes a back cover and a screen, the back cover is arranged at the bottom portion of the middle frame and adhesively connected to the middle frame, and the screen is arranged at the top portion of the middle frame and adhesively connected to the middle frame. The bottom portion of the middle frame is provided with an accommodating groove, and the outer peripheral side of the middle frame is provided with a button through hole. In this way, the accommodating groove is prevented from affecting the bonding area between the middle frame and the back cover, the width of the middle frame may be reduced, and further the width of the mobile phone may be reduced. Certainly, the button assembly may also be located on one side of the mobile phone in the length direction, and in this case, the length of the mobile phone may be reduced.

In some embodiments, in an axial direction of the button through hole 11, the width of the accommodating groove 12 is 0.3 mm-5 mm. Certainly, the width of the accommodating groove 12 may also be set to be less than 0.3 mm or greater than 5 mm according to actual needs.

In some embodiments, referring to Fig. 3 to Fig. 4, the button assembly 5 includes a button body 51 slidably arranged on the housing 1 and a button needle body 511 hermetically arranged in the button through hole 11. The button body 51 drives the button needle body 511 to move in the button through hole 11 to trigger the FPC assembly 4 when being pressed.

It may be understood that the button needle body 511 is hermetically arranged in the button through hole 11 and may move in the button through hole 11, so that the waterproof effect may be ensured while realizing the key function, thereby preventing liquid or water vapor from entering the inner space of the housing 1 through the button through hole 11.

The button body 51 and the button needle body 511 may be integrally formed, or may be separately arranged and connected as a whole.

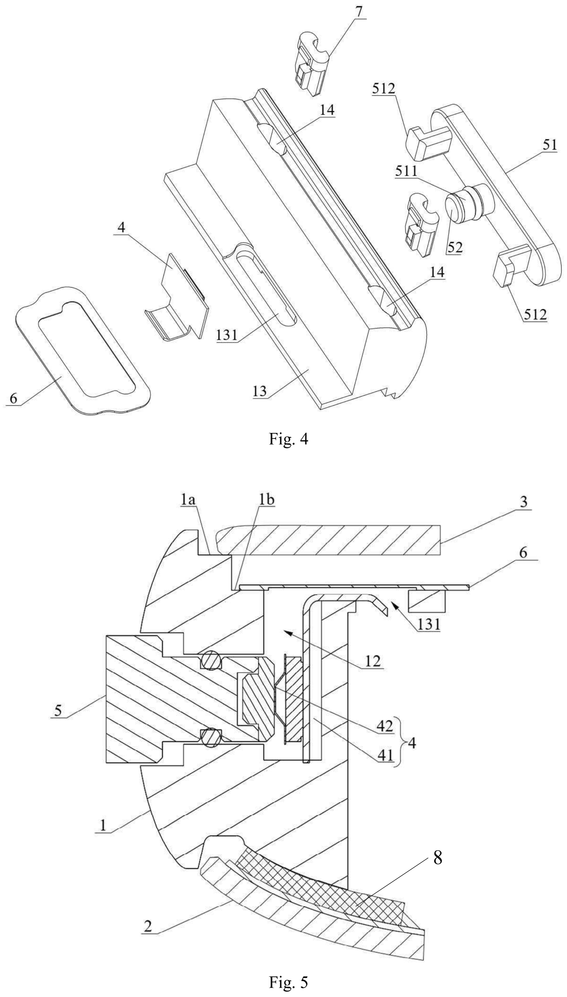

Referring to Fig. 4, the button body 51 is provided with a buckle 512, and a buckle hole 15 for the buckle 512 to extend into is formed in the outer peripheral side of the housing 1. The bottom portion of the housing 1 is provided with a clamping piece accommodating groove 14, and a clamping piece 7 is arranged in the clamping piece accommodating groove 14. The buckle hole 15 is communicated with the clamping piece accommodating groove 14. The buckle 512 may extend into the clamping piece accommodating groove 14 through the buckle hole 15, and the clamping piece 7 may limit the buckle 512 when the button body 51 moves in a direction away from the FPC assembly 4. That is, in a natural state, the button body 51 is in an initial position, and at this time, the buckle 512 is limited by the clamping piece 7. When the button body 51 is pressed to move in a direction toward the FPC assembly 4, the button body 51 drives the buckle 512 to move in the direction toward the FPC assembly 4, and at this time, the buckle 512 is out of contact with the clamping piece 7. When the button body 51 loses the pressing force and moves in the direction away from the FPC assembly 4, the clamping piece 7 may be in contact with the buckle 512 to limit the button body 51 to the initial position.

The button body 51 is provided with two buckles 512, and the housing 1 is correspondingly provided with two clamping pieces 7, so as to improve the stability of limiting the button body 51.

It should be noted that although the clamping piece accommodating groove 14 is arranged in the bottom portion of the housing 1, it does not affect the bonding between the housing 1 and the back cover 2. This is because the bottom portion of the housing 1 has a first area and a second area, the second area is closer to the outer peripheral side of the housing 1 than the first area, the first area is provided with a bonding surface for bonding with the back cover 2, and the second area or a junction between the first area and the second area is provided with the clamping piece accommodating groove 14. In this way, when the accommodating groove is arranged in the first area, the width of the bonding surface at the accommodating groove becomes smaller, which affects the waterproof effect. Therefore, the width of the bonding surface needs to be increased to ensure the waterproof effect, resulting in an increase in the dimension of the intelligent terminal.

Further, a buffer piece 52 capable of contacting the FPC assembly 4 is arranged at the front end of the button needle body 511. By arranging the buffer piece 52, when the button assembly 5 is pressed to trigger the FPC assembly 4, the pressing action may be buffered by the buffer piece 52, so as to prevent the button needle body 511 from being in hard contact with the FPC assembly 4 and damaging the FPC assembly 4.

Referring to Fig. 4, the FPC assembly 4 includes an FPC body 41 and a trigger shrapnel 42 arranged on the FPC body 41. The trigger shrapnel 42 is configured to deform and be triggered when being squeezed by the button assembly 5, and when the button assembly 5 loses the pressing force, the force of the trigger shrapnel 42 to return to its original shape drives the button assembly 5 to return to the initial position.

Further, a button mounting groove 16 communicated with the button through hole 11 is formed in the outer peripheral side of the housing 1. The button body 51 is arranged in the button mounting groove 16, and partially extends out of the button mounting groove 16.

It may be understood that in a natural state, the button body 51 is located in the button mounting groove 16 and partially extends out of the button mounting groove 16, so that a hidden design of part of the button body 51 may be realized, and the button body 51 is prevented from protruding too much beyond the outer peripheral surface of the housing 1 and affecting the aesthetics of the intelligent terminal.

In some embodiments, the intelligent terminal further includes a button bracket (not shown in the figure). The button bracket is arranged in the accommodating groove 12, and a limiting cavity for limiting the FPC assembly 4 is arranged on the button bracket.

It may be understood that the FPC assembly 4 is fixed in the accommodating groove 12 by the button bracket. The button bracket is clamped in the accommodating groove 12 by matching with the size of the accommodating groove 12, or may be fixed in the accommodating groove 12 by bonding, screwing, etc., which is not specifically limited herein.

Exemplarily, the button bracket may be U-shaped, and the U-shaped cavity of the button bracket constitutes the limiting cavity. In this case, the FPC assembly 4 is clamped between the side walls of the button bracket, that is, in the U-shaped cavity, so as to realize the fixing of the FPC assembly 4.

In some embodiments, referring to Fig. 4 and Fig. 5, the intelligent terminal further includes a sealing piece 6 connected to the housing 1 and covering the accommodating groove 12 to separate the accommodating groove 12 from the screen 3.

It may be understood that by arranging the sealing piece 6, the accommodating groove 12 may be covered, and the accommodating groove 12 is separated from the screen 3. In this way, on the basis of utilizing the sealing between the screen 3 and the housing 1, the sealing may be further realized by the sealing piece 6, the waterproof effect is improved, and the sealing piece 6 may also play a role of limiting the FPC assembly 4 to prevent the FPC assembly 4 from falling out of the accommodating groove 12.

Further, the housing 1 has an ear plate 13 extending toward the inner side of the housing 1. A through hole 131 for the FPC assembly 4 to pass through is formed in the ear plate 13. The FPC assembly 4 extends out of the accommodating groove 12 and extends to the inner side of the housing 1 through the through hole 131. The sealing piece 6 covers the through hole 131.

That is, the through hole 131 is formed in the ear plate 13, and the sealing piece 6 hermetically covers the through hole 131 and the opening of the accommodating groove 12, so that the FPC assembly 4 may be separated from the screen 3 by the sealing piece 6, and the through hole 131 and the notch of the accommodating groove 12 are completely covered by the sealing piece 6, further improving the waterproof effect of the intelligent terminal.

The sealing piece 6 may be selected as a sealing gasket, and the sealing gasket is adhesively connected to the housing 1. Certainly, the sealing piece may also be selected to be fixed by a screw, and in this case, a sealing ring may be further arranged between the sealing piece and the housing to improve the sealing effect.

Referring to Fig. 5, the top portion of the housing 1 is provided with a stepped surface of a first supporting surface 1a and a second supporting surface 1b. The accommodating groove 12 is arranged in the housing 1 at the second supporting surface 1b. The screen 3 is arranged on the first supporting surface 1a.

It may be understood that the first supporting surface 1a is higher than the second supporting surface 1b, so that the screen 3 is arranged on the first supporting surface 1a, and the second supporting surface 1b is located on the inner side of the screen 3. In this way, the arrangement of the accommodating groove 12 does not affect the fixing between the screen 3 and the housing 1, and the sealing between the screen 3 and the housing 1 may also be used to realize the sealing of the accommodating groove 12.

The screen 3 is adhesively connected to the housing 1, and the arrangement of the second supporting surface 1b also provides a bonding area for the screen 3 and the housing 1, thereby ensuring the bonding stability between the screen 3 and the housing 1.

Further, the sealing piece 6 is in sealing fit with the second supporting surface 1b. It should be noted that the upper surface of a side of the ear plate 13 facing the screen 3 is level with the second supporting surface 1b, so that the sealing piece 6 is in sealing fit with the second supporting surface 1b and the upper surface of the ear plate 13, thereby realizing the sealing of the notch of the accommodating groove 12 and the through hole 131, and realizing the sealing separation of the FPC assembly 4 and the screen 3.

Exemplarily, referring to Fig. 2 to Fig. 5, taking the intelligent terminal as a mobile phone for an example, the mobile phone includes a housing 1, a back cover 2, a screen 3, an FPC assembly 4, a button assembly 5 and a button bracket. The housing 1 presents an annular structure. The back cover 2 is arranged at the bottom portion of the housing 1 and hermetically connected to the housing 1. The screen 3 is arranged at the top portion of the housing 1 and hermetically connected to the housing 1. The button assembly 5 is located on one side of the mobile phone in the width direction.

A side of the housing 1 facing the screen 3 is provided with an accommodating groove 12. The button bracket is arranged in the accommodating groove 12, and the button bracket has a limiting cavity for accommodating the FPC assembly 4. The FPC assembly 4 includes an FPC body 41 and a trigger shrapnel 42, and the FPC body 41 is limited in the limiting cavity.

A button through hole 11 is formed in an outer peripheral side of the housing 1. The button assembly 5 includes a button body 51 slidably arranged on the housing 1 and a button needle body 511 hermetically arranged in the button through hole 11, where the button body 51 and the button needle body 511 are integrally formed. A buffer piece 52 capable of contacting the FPC assembly 4 is arranged at the front end of the button needle body 511. In a natural state, the button assembly 5 is in an initial position, and the button body 51 drives the button needle body 511 to move in a direction toward the FPC assembly 4 to trigger the FPC assembly 4 when being pressed. When the button body 51 loses the pressing force, the trigger shrapnel 42 drives the button body 51 to move in a direction away from the FPC assembly 4 to return to the initial position.

The button body 51 is provided with a buckle 512, and a buckle hole 15 for the buckle 512 to extend into is formed in the outer peripheral side of the housing 1. The bottom portion of the housing 1 is provided with a clamping piece accommodating groove 14, and a clamping piece 7 is arranged in the clamping piece accommodating groove 14. The buckle hole 15 is communicated with the clamping piece accommodating groove 14. The buckle 512 may extend into the clamping piece accommodating groove 14 through the buckle hole 15, and the clamping piece 7 may limit the buckle 512 when the button body 51 moves in a direction away from the FPC assembly 4. That is, in a natural state, the button body 51 is in an initial position, and at this time, the buckle 512 is limited by the clamping piece 7. When the button body 51 is pressed to move in a direction toward the FPC assembly 4, the button body 51 drives the buckle 512 to move in the direction toward the FPC assembly 4, and at this time, the buckle 512 is out of contact with the clamping piece 7. When the button body 51 loses the pressing force and moves in the direction away from the FPC assembly 4, the clamping piece 7 may be in contact with the buckle 512 to limit the button body 51 to the initial position.

The bottom portion of the housing 1 has a first area and a second area, the second area is closer to the outer peripheral side of the housing 1 than the first area, the first area is provided with a bonding surface for bonding with the back cover 2, and the clamping piece accommodating groove 14 is arranged at a junction between the first area and the second area.

The intelligent terminal further includes a sealing piece 6 connected to the housing 1 and covering the accommodating groove 12 to separate the accommodating groove 12 from the screen 3.

Further, the housing 1 has an ear plate 13 extending toward the inner side of the housing 1. A through hole 131 for the FPC assembly 4 to pass through is formed in the ear plate 13. The FPC assembly 4 extends out of the accommodating groove 12 and extends to the inner side of the housing 1 through the through hole 131. The sealing piece 6 covers the through hole 131.

That is, the through hole 131 is formed in the ear plate 13, and the sealing piece 6 hermetically covers the through hole 131 and the opening of the accommodating groove 12, so that the FPC assembly 4 may be separated from the screen 3 by the sealing piece 6, and the through hole 131 and the notch of the accommodating groove 12 are completely covered by the sealing piece 6, further improving the waterproof effect of the intelligent terminal.

The sealing piece 6 may be selected as a sealing gasket, and the sealing gasket is adhesively connected to the housing 1. Certainly, the sealing piece may also be selected to be fixed by a screw, and in this case, a sealing ring may be further arranged between the sealing piece and the housing to improve the sealing effect.

The top portion of the housing 1 is provided with a stepped surface of a first supporting surface 1a and a second supporting surface 1b. The accommodating groove 12 is arranged in the housing 1 at the second supporting surface 1b. The screen 3 is arranged on the first supporting surface 1a. The screen 3 is adhesively connected to the housing 1.

Further, the sealing piece 6 is in sealing fit with the second supporting surface 1b. It should be noted that the upper surface of a side of the ear plate 13 facing the screen 3 is level with the second supporting surface 1b, so that the sealing piece 6 is in sealing fit with the second supporting surface 1b and the upper surface of the ear plate 13, thereby realizing the sealing of the notch of the accommodating groove 12 and the through hole 131, and realizing the sealing separation of the FPC assembly 4 and the screen 3.

It should be noted that in this paper, relational terms such as "first" and "second" are only used to distinguish one entity or operation from another entity or operation, and do not necessarily require or imply any actual relationship or order between these entities or operations. Moreover, terms "include", "include" or any other variation thereof are intended to cover non-exclusive inclusion, so that a process, method, object or device including a series of elements includes not only those elements, but also other elements not explicitly listed or elements inherent to such process, method, object or device. Without further restrictions, an element defined by a phrase "including a" does not exclude that there are other identical elements in the process, method, object or device including the element.

The above descriptions are only specific embodiments of the present disclosure, so that those skilled in the art may understand or implement the present disclosure. Various modifications to these embodiments will be obvious to those skilled in the art, and general principles defined herein may be implemented in other embodiments without departing from the spirit or scope of the present disclosure. Therefore, the present disclosure will not be limited to the embodiments described herein, but rather to the widest scope consistent with the principles and novel features disclosed herein.

## Claims

1. An intelligent terminal, comprising a housing (1), a back cover (2), a screen (3), an FPC assembly (4) and a button assembly (5), wherein the back cover (2) is arranged at a bottom portion of the housing (1) and hermetically connected to the housing (1), the screen (3) is arranged at a top portion of the housing (1) and hermetically connected to the housing (1), a button through hole (11) for the button assembly (5) to extend into is formed in an outer peripheral side of the housing (1), a side of the housing (1) facing the screen (3) is provided with an accommodating groove (12) for accommodating the FPC assembly (4), the accommodating groove (12) is communicated with the button through hole (11), and the screen (3) covers the accommodating groove (12).

2. The intelligent terminal according to claim 1, wherein the accommodating groove (12) is a groove recessed into the housing (1) from a surface of the housing (1) facing the screen (3).

3. The intelligent terminal according to claim 1, further comprising a sealing piece (6) connected to the housing (1) and covering the accommodating groove (12) to separate the accommodating groove (12) from the screen (3).

4. The intelligent terminal according to claim 3, wherein the housing (1) comprises an ear plate (13) extending toward an inner side of the housing (1), a through hole (131) for the FPC assembly (4) to pass through is formed in the ear plate (13), a part of the FPC assembly (4) extends out of the accommodating groove (12) and extends to the inner side of the housing (1) through the through hole (131), and the sealing piece (6) hermetically covers the through hole (131).

5. The intelligent terminal according to any one of claims 1-4, further comprising a button bracket arranged in the accommodating groove (12) and provided with a limiting cavity for limiting the FPC assembly (4).

6. The intelligent terminal according to claim 5, wherein the button bracket is U-shaped, and the FPC assembly (4) is clamped between side walls of the button bracket.

7. The intelligent terminal according to any one of claims 1-6, wherein in an axial direction of the button through hole (11), a width of the accommodating groove (12) is 0.3 mm-5 mm.

8. The intelligent terminal according to any one of claims 1-7, wherein the top portion of the housing (1) is provided with a stepped surface comprising a first supporting surface (1a) and a second supporting surface (1b), the accommodating groove (12) is formed in the housing (1) at the second supporting surface (1b), and the screen (3) is arranged on the first supporting surface (1a).

9. The intelligent terminal according to claim 8, wherein the accommodating groove (12) is located at an inner side of second supporting surface (1b) away from the first supporting surface (1a) in axial direction of the button through hole (11).

10. The intelligent terminal according to any one of claims 1-9, wherein the button assembly (5) comprises a button body (51) slidably arranged on the housing (1) and a button needle body (511) hermetically arranged in the button through hole (11), and the button body (51) is configured to drive the button needle body (511) to move in the button through hole (11) to trigger the FPC assembly (4) when being pressed.

11. The intelligent terminal according to claim 10, wherein a front end of the button needle body (511) is provided with a buffer piece (52) capable of contacting the FPC assembly (4).

12. The intelligent terminal according to claim 10, wherein an outer peripheral side of the housing (1) is provided with a button mounting groove (16) communicated with the button through hole (11), and the button body (51) is arranged in the button mounting groove (16) and partially extends out of the button mounting groove (16).

13. The intelligent terminal according to any one of claims 1-12, wherein the back cover (2) is hermetically connected to the housing (1) through a sealant (8), an orthographic projection of the accommodating groove (12) on the back cover (2) is overlapped with an orthographic projection of the sealant (8) on the back cover (2).

14. The intelligent terminal according to any one of claims 1-13, wherein the intelligent terminal is a mobile phone.

15. The intelligent terminal according to claim 14, wherein the housing (1) is a middle frame of the mobile phone.
